# EUROPÄISCHE PATENTSCHRIFT

(11) **EP 1 206 802 B1**
(45) Veröffentlichungstag und Bekanntmachung des Hinweises auf die Patenterteilung: **19.03.2008**
(21) Anmeldenummer: 01943141.0
(22) Anmeldetag: 23.05.2001
(51) Int. Cl.: H01L 33/00, C09K 11/77

(54) **WEISS EMITTIERENDE BELEUCHTUNGSEINHEIT AUF LED-BASIS**
LED-BASED WHITE-LIGHT EMITTING LIGHTING UNIT
UNITE D'ECLAIRAGE EMETTANT UNE LUMIERE BLANCHE, A BASE D'UNE DIODE ELECTROLUMINESCENTE

(30) Priorität: 29.05.2000 DE 10026435; 11.05.2001 DE 20108013 U
(43) Veröffentlichungstag der Anmeldung: 22.05.2002
(73) Patentinhaber: Patent-Treuhand-Gesellschaft für elektrische Glühlampen mbH, 81543 München (DE); Osram Opto Semiconductors GmbH, 93055 Regensburg (DE)
(72) Erfinder: ELLENS, Andries, 6716 CC Ede (NL); JERMANN, Frank, 81739 München (DE); ZWASCHKA, Franz, 85737 Ismaning (DE); KUMMER, Franz, 80797 München (DE); OSTERTAG, Michael, 81549 MUNCHEN (DE)
(74) Vertreter: Pokorny, Gerd
(86) Internationale Anmeldenummer: PCT/DE2001/001955
(87) Internationale Veröffentlichungsnummer: WO 2001/093342

(56) Entgegenhaltungen:
- WO-A-00/57490
- WO-A-98/39805
- DE-A- 19 638 667
- XIAO ZHANG ET AL: "LUMINESCENCE PROPERTIES AND ENERGY TRANSFER OF EU2+ DOPED CA8MG(SIO4)4CL2 PHOSPHORS" JOURNAL OF THE ELECTROCHEMICAL SOCIETY, ELECTROCHEMICAL SOCIETY. MANCHESTER, NEW HAMPSHIRE, US, Bd. 139, Nr. 2, 1. Februar 1992 (1992-02-01), Seiten 622-625, XP000334401 ISSN: 0013-4651 in der Anmeldung erwähnt

## Beschreibung

### Technisches Gebiet

Die Erfindung betrifft eine Weiß emittierende Beleuchtungseinheit auf LED-Basis, wobei die LED primär UV-Strahlung oder blaues Licht emittiert. Außerdem werden zumindest ein gelb und ein grün emittierender Leuchtstoff zur teilweisen Konversion der Primärstrahlung verwendet. Als gelber Leuchtstoff wird ein Ce-aktivierter Granat, der insbesondere Y und/oder Tb enthält verwendet, eingesetzt. Als grüner Leuchtstoff wird ein Eu-aktiviertes Calcium-Magnesium-Chlorosilikat (Ca₈Mg(SiO₄)₄Cl₂) eingesetzt.

### Stand der Technik

Aus dem J. Electrochem. Soc. 1992, S. 622 ist bereits ein Chlorosilikat-Leuchtstoff und seine Anwendung für UV und Blaulicht-Anregung bekannt, der mit Eu dotiert ist (Luminescence Properties and Energy Transfer of Eu²⁺ Doped Ca₈Mg(SiO₄)₄Cl₂ Phosphors). Dieser leuchtet im Grünen. Ein konkretes Anwendungsgebiet für diesen Leuchtstoff ist nicht beschrieben.

Lumineszenz-Konversions-LEDs, die weißes Licht abgeben, werden derzeit durch die Kombination einer etwa bei 460 nm emittierenden blauen Ga(In)N-LED und eines gelb emittierenden YAG:Ce³⁺-Leuchtstoffs erzeugt (US 5 998 925 und EP 862 794). Allerdings sind diese Weißlicht-LEDs für Zwecke der Allgemeinbeleuchtung wegen ihrer schlechten Farbwiedergabe aufgrund fehlender Farbkomponenten (vor allem des Rot-Anteils) nur eingeschränkt zu gebrauchen. Eine Alternative ist die Mischung von drei Farben RGB (rot, grün, blau), die zusammen weiß ergeben, siehe beispielsweise WO 98/39805.

### Darstellung der Erfindung

Es ist Aufgabe der vorliegenden Erfindung, eine Beleuchtungseinheit auf Basis einer LED gemäß dem Oberbegriff des Anspruchs 1 bereitzustellen, die weiß emittiert und insbesondere eine hohe Farbwiedergabe besitzt.

Diese Aufgaben werden durch die kennzeichnenden Merkmale des Anspruchs 1 gelöst. Besonders vorteilhafte Ausgestaltungen finden sich in den abhängigen Ansprüchen.

Bisherige Lösungen für eine weiße LED basieren insbesondere entweder auf dem RGB-Ansatz, also der Mischung von drei Farben, nämlich rot, grün und blau, wobei die letztere Komponente durch einen Leuchtstoff oder durch die primäre Emission der LED realisiert werden kann. Eine zweite vereinfachte Lösung basiert auf der Mischung von blau und gelb (BG-Ansatz), wie eingangs diskutiert.

Erfindungsgemäß wird erstmals ein ganz neues Konzept angewendet, das auf einer BGG-Mischung basiert, also der Kombination einer blauen, gelben und grünen Farbe. Wesentlich dabei ist, dass die gelben Leuchtstoffe dabei so breitbandig sind, dass sie auch einen ausreichenden Anteil der Emission im roten Spektralbereich aufweisen, insbesondere einen Anteil von mindestens 20 % ihrer Gesamtemission im Sichtbaren in einem Spektralbereich ≥ 620 nm.

Als geeigneter gelb emittierender Leuchtstoff zeigt sich insbesondere ein Ce-aktivierter Granat der seltenen Erden (SE), bevorzugt mit SE ausgewählt aus Y, Tb, Gd, Lu, und/oder La. Bevorzugt ist eine Kombination von Y und Tb. Dabei wirkt die langwellige Verschiebung durch Tb besonders positiv im Sinne eines ausreichenden Rotanteils.

Als grün emittierender Leuchtstoff (bevorzugt liegt seine Peakemissionswellenlänge im Bereich 500 bis 525 nm) eignet sich besonders bevorzugt ein Ca-Mg-Chlorosilikat-Grundgerüst, das erfindungsgemäß mit Europium (Eu) dotiert ist. Evtl. können auch geringe Mengen an weiteren Dotierstoffen, insbesondere an Mangan (Mn) in kleinen Anteilen zur Feinabstimmung hinzugefügt werden. Eine weitere Alternative ist ein grüner Leuchtstoff vom Typ SrAl₂O₄:Eu²⁺ oder Sr₄Al₁₄O₂₅:Eu²⁺.

Der Farbort des grünen Leuchtstoffs spannt im Farbdiagramm zusammen mit dem Farbort des gelben Leuchtstoffs und dem der blauen LED (bzw. des blauen Leuchtstoffs) ein breites Dreieck auf, wodurch zusätzliche Möglichkeiten der Anpassung an spezielle Anforderungen geschaffen werden. Die Variationsbreite des Farborts unterschiedlicher Granate ist dagegen deutlich geringer. Somit lässt sich auch die erzielbare Farbtemperatur über einen weiten Bereich, typisch von 4000 bis 10000 K, streuen.

Die Erfindung ist besonders vorteilhaft im Zusammenhang mit der Entwicklung einer im Weißen emittierenden Beleuchtungseinheit. Dabei handelt es sich um eine Beleuchtungseinheit, die entweder auf einem LED-Feld (Array) oder einzelnen LEDs basiert, oder direkt um eine Lumineszenz-Konversions-LED, bei der die Leuchtstoffe direkt oder mittelbar in Kontakt mit dem Chip stehen, also direkt auf den Chip aufgetragen sind oder in dem ihn umgebenden Harz eingebettet sind.

Die Erzeugung von weißem Licht kann realisiert werden durch Kombination von UV oder blaues Licht (hier zusammenfassend als "kurzwellig" bezeichnet) emittierenden LEDs mit einer Emissionswellenlänge (Peak) zwischen 300 und 470 nm und der erfindungsgemäßen Leuchtstoffmischung, die die Strahlung der LED ganz oder teilweise absorbiert und selbst in Spektralbereichen emittiert, deren additive Mischung mit dem Licht der LED weißes Licht mit guter Farbwiedergabe ergibt. Evtl. muss eine zusätzliche blau emittierende Leuchtstoffkomponente (beispielsweise BAM) hinzugefügt werden. Eine besonders effiziente Anregung gelingt im Falle einer UV-LED bei einer Emissionswellenlänge (Peak) von etwa 330 bis 350 nm und im Falle einer blauen LED bei einer Emissionswellenlänge (Peak) von etwa 450 bis 470 nm.

Damit wird eine verbesserte Farbwiedergabe der bekannten weißen LED auf Basis eines Granat-Leuchtstoffs erzielt, beispielsweise durch Beimischung von 20 bis 50 Gew.-% des Chlorosilikat-Leuchtstoffs. Der gelb emittierende Leuchtstoff ist ein Granat der Seltenen Erden (SE) Y, Gd, Lu, La und/oder Tb gemäß der Formel SE₃(Al,Ga)₅O₁₂:Ce, insbesondere mit SE = Y und/oder Tb, insbesondere entsprechend der Formel YAG:Ce oder TbAG:Ce.

Der Leuchtstoff Ca₈Mg(SiO₄)₄Cl₂:Eu²⁺ ist aus der wissenschaftlichen Literatur bekannt, ohne dass dort irgendeine konkrete Anwendung angegeben wäre. Dieser Leuchtstoff zeigt erfindungsgemäß eine gute Eignung für die Anwendung bei weißen LEDs, besonders vorteilhaft auf Basis einer Drei-Farben-Mischung, die von einer primären UV-Lichtquelle angeregt wird (300 bis 390 nm). Aber auch für Spezialanwendungen bei einer weißen LED mit blauer Primär-Lichtquelle (430 bis 470 nm) ist er geeignet. Der Anteil x des Europium beträgt vorteilhaft zwischen x = 0,005 und 1,6 und insbesondere zwischen x = 0,01 und x = 1,0. Dabei ist als Summenformel Ca₈₋ₓEuₓMg(SiO₄)₄Cl₂ angenommen.

Die Zugabe von Mn als weiterer Dotierstoff neben Eu in kleinen Mengen (bis zu etwa 20 % des Molanteils von Eu) bietet die Möglichkeit, die Emission gezielt aus dem grünen Spektralbereich etwas mehr zum Langwelligen hin zu verschieben, also in den gelben Spektralbereich. Dies hat den Vorteil, die Emission besser an das menschliche Auge anpassen zu können und damit auch den visuellen Nutzeffekt zu verbessern. Der Anteil y des Mn sollte dabei höchstens bei y = 0,1 liegen. Besonders bevorzugt ist der Anteil des Europiums zwischen x = 0,05 und 0,8 ohne dass Mangan hinzugefügt wird.

Die Europiumkonzentration beeinflusst den Farbort des Emissionslichts beim Einsatz in einer Lichtquelle, insbesondere LED. Über das Verhältnis der beiden Konzentrationen Eu:Mn lässt sich der Farbort dieses Leuchtstoffs zusätzlich fein einstellen, was die Anpassung an etwaige weitere (gelbe bzw. blaue) Leuchtstoffe in der LED vereinfacht bzw. optimiert.

Die erfindungsgemäßen Leuchtstoffe können beispielsweise auch in einem Gerät angewendet werden, in dem ein LED-Array (UV oder blau primär emittierend) Leuchtstoffe auf einer transparenten Scheibe beleuchtet oder in dem einzelne LEDs Leuchtstoffe beleuchtet, die auf einer Linse aufgebracht sind.

Besonders vorteilhaft werden die erfindungsgemäßen Leuchtstoffe angewendet um eine weiße LED hoher Farbwiedergabe zu realisieren. Dazu werden die Leuchtstoffe entweder separat oder in Mischung aufgetragen und evtl. mit einem möglichst transparenten Bindemittel kombiniert (EP 862 794). Die Leuchtstoffe absorbieren das Licht der UV/Blau-Licht emittierenden LED ganz oder teilweise und emittieren es in anderen Spektralbereichen (vornehmlich gelb und grün) wieder so breitbandig (nämlich mit merklichem Rotanteil), dass eine Gesamtemission mit gewünschtem Farbort entsteht. Bisher gibt es kaum Leuchtstoffe, die diese Anforderungen so gut erfüllen wie die hier beschriebenen Leuchtstoffe in ihrer Kombination. Sie zeigen eine hohe Quanteneffizienz (um 70 %) und gleichzeitig eine spektrale Emission, die aufgrund der Empfindlichkeit des Auges als hell empfunden wird. Der Farbort lässt sich in einem weiten Bereich einstellen.

Als Lichtquelle eignet sich eine LED (light emitting diode), die weißes Licht erzeugt, entweder über direkte Mischung des grün- bzw. gelb-emittierenden Leuchtstoffs mit der primären Strahlung im blauen Spektralbereich (430 bis 470 nm) oder indem eine primär UV emittierende Strahlung mittels mehrerer Leuchtstoffe in Weiß konvertiert wird (vollständige BGG-Mischung mittels dreier Leuchtstoffe). Allgemein sollen unter den Begriffen blau, gelb und grün hier Emissionsmaxima in den Bereichen Blau: 430 bis 470 nm, Grün: 490 bis 525 nm und Gelb: 545 bis 590 nm verstanden werden.

Als primäre Lichtquelle dient die Strahlung eines UV- oder blau-emittierenden Chips. Besonders gute Ergebnisse werden mit einer UV-LED erzielt, deren Emissionsmaximum bei 330 bis 370 nm liegt. Unter besonderer Berücksichtigung des Anregungsspektrums der Granate und Chlorosilikate zeigt sich ein Optimum bei 355 bis 365 nm. Als blauer Leuchtstoff dient hier beispielsweise BAM. Bei einem blauen Chip lassen sich besonders gute Ergebnisse mit einer Peakwellenlänge von 430 bis 470 nm erzielen. Unter besonderer Berücksichtigung des Anregungsspektrums der Granate und Chlorosilikate zeigt sich ein Optimum bei 445 bis 460 nm.

Eine Variante mit besonders guter Farbwiedergabe ist die gemeinsame Verwendung zweier Leuchtstoffe, eines hoch Tb-haltigen Leuchtstoffs, bev. reines TbAG:Ce, zusammen mit Chlorosilikat:Eu. Eine Variante mit besonders guter Temperaturstabilität ist die gemeinsame Verwendung zweier Leuchtstoffe, eines hoch Y-haltigen Leuchtstoffs, bev. reines YAG:Ce, zusammen mit Chlorosilikat:Eu.

Als LED, die als Primärstrahlung UV- oder blaue Strahlung (im folgenden zusammenfassend als kurzweilige Strahlung bezeichnet) emittiert, eignet sich insbesondere eine Ga(In)N-LED, aber auch jede andere kurzwellig emittierende LED mit einer Emission im Bereich 300 bis 470 nm. Insbesondere wird als hauptsächlicher Emissionsbereich im UV 320 bis 360 nm und im blauen Bereich 430 bis 470 nm empfohlen, da dann die Effizienz am höchsten ist.

### Figuren

Im folgenden soll die Erfindung anhand mehrerer Ausführungsbeispiele näher erläutert werden. Es zeigen:
- Figur 1: das Anregungs- und Emissionsspektrum eines mit Europium dotierten Chlorosilikats;
- Figur 2: das Reflexions- und Emissionsspektrum eines weiteren mit Europium dotierten Chlorosilikats;
- Figur 3: ein Halbleiterbauelement, das als Lichtquelle (LED) für weißes Licht dient;
- Figur 4: das Emissionsspektrum der LED aus Figur 3 mit den Leuchtstoffen TbAG und CS:Eu gemäß der vorliegenden Erfindung;
- Figur 5: das Emissionsspektrum einer weiteren LED mit den Leuchtstoffen TbAG und CS:Eu gemäß der vorliegenden Erfindung;
- Figur 6: das Temperaturverhalten einer LED mit den Leuchtstoffen YAG und CS:Eu gemäß der vorliegenden Erfindung;
- Figur 7: das Emissionsspektrum einer LED mit den Leuchtstoffen YAG und CS:Eu gemäß der vorliegenden Erfindung;
- Figur 8: eine Beleuchtungseinheit mit Leuchtstoffen gemäß der vorliegenden Erfindung.

### Beschreibung der Figuren

Im folgenden wird beispielhaft die Synthese eines Eu- und Mn-dotierten Chlorosilikats Ca₈Mg(SiO₄)₄Cl₂:(Eu²⁺,Mn²⁺) genauer beschrieben. Danach wird anhand einiger Beispielmessungen die Eignung dieses Leuchtstoffs dokumentiert.

Das Leuchtstoffpulver wird durch eine Hochtemperatur-Festkörperreaktion hergestellt. Dazu werden beispielsweise die hochreinen Ausgangsmaterialien CaCO₃, MgO, SiO₂ und CaCl₂ zusammengemischt mit einem Mol-Verhältnis von 7:1:4:1,5. Eine kleine Menge Eu₂O₃ bzw. MnCO₃ wird zum Zwecke der Dotierung hinzugefügt und ersetzt dabei die entsprechende Molmenge CaCO₃. Dies entspricht der Bruttoformel

Ca_{8-x-y}EuₓMn_{y}Mg(SiO₄)₄Cl₂, zuzüglich 0,5 CaCl₂.

Nachdem die einzelnen Komponenten gut vermischt worden sind, wird das Pulver bei 1000 - 1200 °C für 1 - 4 h in einer reduzierenden Atmosphäre (H₂/N₂) erhitzt und reagiert so zu der oben angegebenen Verbindung. Um überschüssiges CaCl₂ und andere wasserlösliche Fremdphasen zu entfernen, kann das Pulver noch einmal mit voll entionisiertem Wasser gewaschen werden. Man erhält ein Leuchtstoffpulver mit hohen Quanteneffizienzen (typisch etwa 70 %) bei einer Anregung im kurzwelligen Wellenlängenbereich um 400 nm.

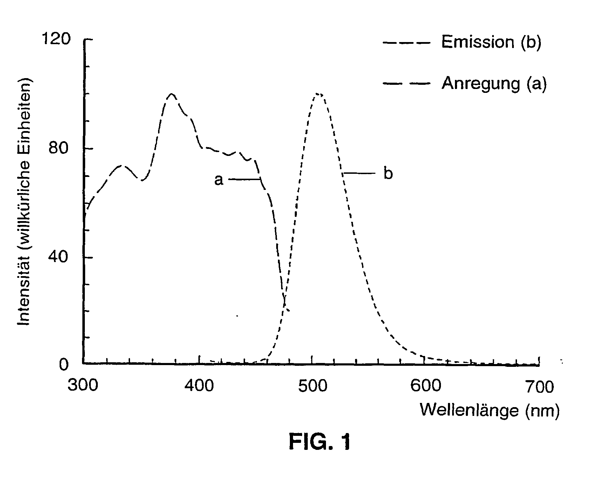

Figur 1 zeigt ein typisches Anregungs- und Emissionsspektrum eines europiumdotierten Pulvers. Der Zusatz an Eu₂O₃ beträgt 0,03 mol, d.h. x = 0,06. Die effiziente Anregbarkeit über einen sehr breiten Wellenlängenbereich von 300 bis 470 nm, vor allem 360 bis 400 nm, ist gut erkennbar. Die Abnahme der Anregbarkeit bei größeren Wellenlängen ist bedingt durch die Eu²⁺-Absorptionsbande. Bei 460 nm werden jedoch noch vergleichbare Quanteneffizienzen gemessen wie bei 400 nm oder auch kurzwelliger (bis herab zu etwa 340 nm).

Das Emissionsspektrum zeigt eine Eu²⁺-Emissionsbande mit einem Maximum bei etwa 507 nm. Diese Emission wirkt auf das Auge grün. Mittels einer geringen Co-Dotierung mit Mangan kann, falls gewünscht, das Emissionsverhalten des Leuchtstoffs besser an die Empfindlichkeit des Auges angepasst werden.

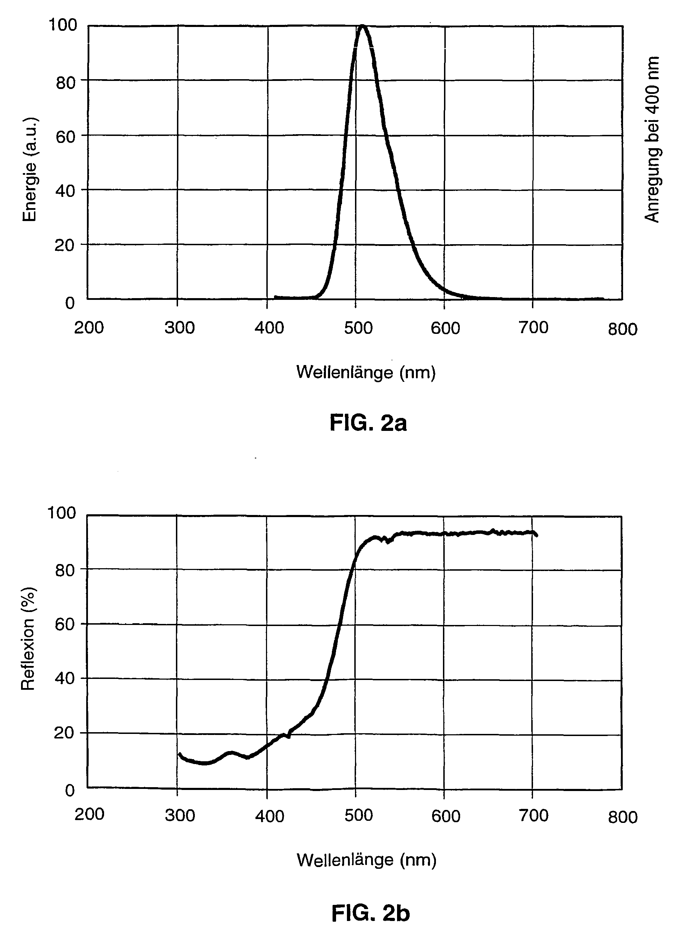

Figur 2 zeigt ein weiteres Ausführungsbeispiel eines Eu-dotierten Chlorosilikats Ca₈Mg(SiO₄)₄Cl₂:Eu²⁺ (abgekürzt CS:Eu). Der Zusatz an Eu₂O₃ beträgt 0,2 mol, d.h. x = 0,4. Die Peakwellenlänge liegt bei 509 nm, die mittlere Wellenlänge bei 522 nm. Die Farbkoordinaten sind x = 0.185 und y = 0.615. Die Emission unter Bestrahlung bei 400 nm ist in Figur 2a in willkürlichen Einheiten angegeben. Weiter ist auch die Reflexion (in Prozent) in Figur 2b angegeben.

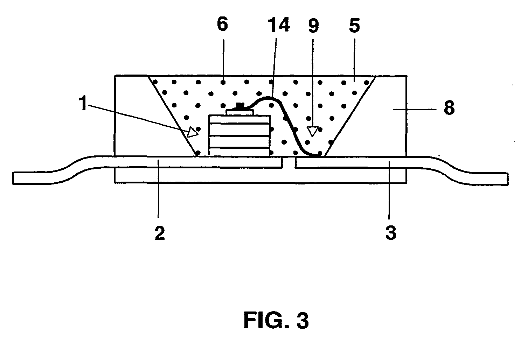

Für den Einsatz in einer weißen LED zusammen mit einem GaInN-Chip wird beispielsweise ein Aufbau ähnlich wie in US 5 998 925 beschrieben verwendet. Der Aufbau einer derartigen Lichtquelle für weißes Licht ist in Figur 3 explizit gezeigt. Die Lichtquelle ist ein Halbleiterbauelement (Chip 1) des Typs InGaN mit einer Peakemissionswellenlänge von 450 nm mit einem ersten und zweiten elektrischen Anschluss 2,3, das in ein lichtundurchlässiges Grundgehäuse 8 im Bereich einer Ausnehmung 9 eingebettet ist. Einer der Anschlüsse 3 ist über einen Bonddraht 14 mit dem Chip 1 verbunden. Die Ausnehmung hat eine Wand 17, die als Reflektor für die blaue Primärstrahlung vom Chip 1 dient. Die Ausnehmung 9 ist mit einer Vergussmasse 5 gefüllt, die als Hauptbestandteile ein Epoxidgießharz (80 bis 90 Gew.-%) und Leuchtstoffpigmente 6 (weniger als 15 Gew.-%) enthält. Weitere geringe Anteile entfallen u.a. auf Methylether und Aerosil.

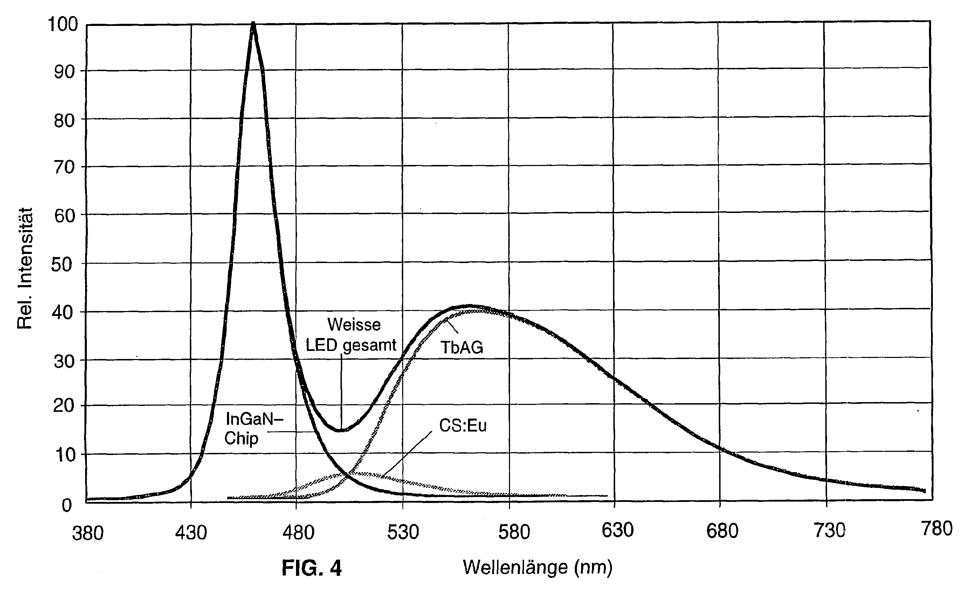

Dabei wird der Chlorosilikat-Leuchtstoff (CS:Eu) des zweiten Ausführungsbeispiels zusammen mit TbAG:Ce für die Leuchtstoffpigmente verwendet. Das Mischungsverhältnis (CS:Eu) zu TbAG beträgt 4:6 (Gewichtsanteile). Dieses Ausführungsbeispiel zeichnet sich durch besonders hohe Farbwiedergabe von Ra = 85 aus. Das Emissionsspektrum dieses Ausführungsbeispiels ist in Figur 4 gezeigt.

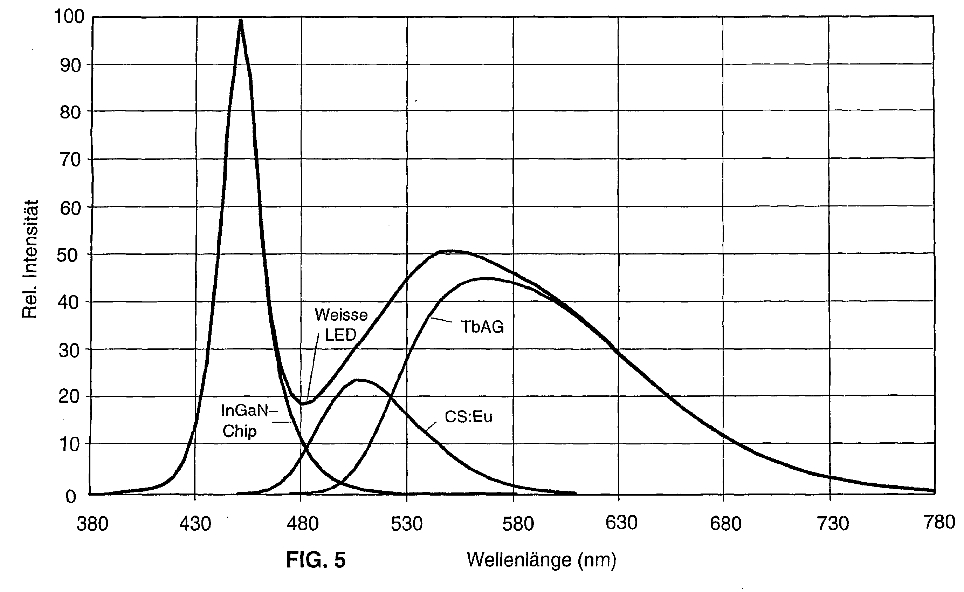

Ein direkter Vergleich zwischen einer konventionellen Lösung (BG) und einer erfindungsgemäßen Lösung (BGG) zeigt folgendes Ergebnis: als BG-Lösung wurde ein blau emittierender InGaN-Chip (Peak bei 450 nm) zusammen mit konventionellem YAG:Ce gewählt. Als erfindungsgemäße BGG-Lösung wurde die gleiche LED zusammen mit TbAG:Ce und CS:Eu gewählt. Dabei wird jeweils eine Farbtemperatur von 6000 K bei einem Farbort mit x = 0,322 und y = 0,366 erzielt. Während die einfache BG-Lösung lediglich eine Farbwiedergabe von Ra = 72 erreicht, gelingt mit der BGG-Lösung eine Farbwiedergabe von Ra = 80. Auch die Rotwiedergabe ist stark verbessert, nämlich von R9 = -22 auf R9 = 10. Das Emissionsspektrum der BGG-Lösung ist in Figur 5 gezeigt.

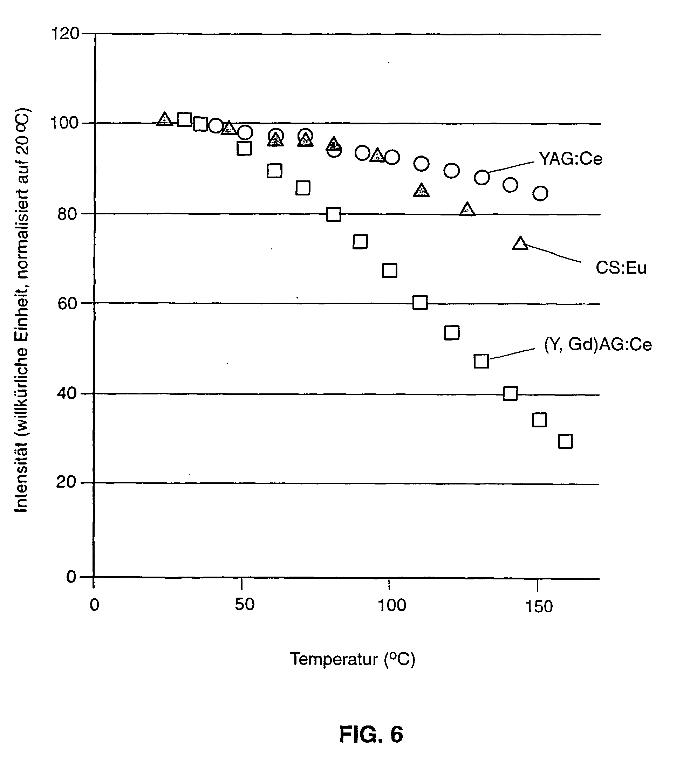

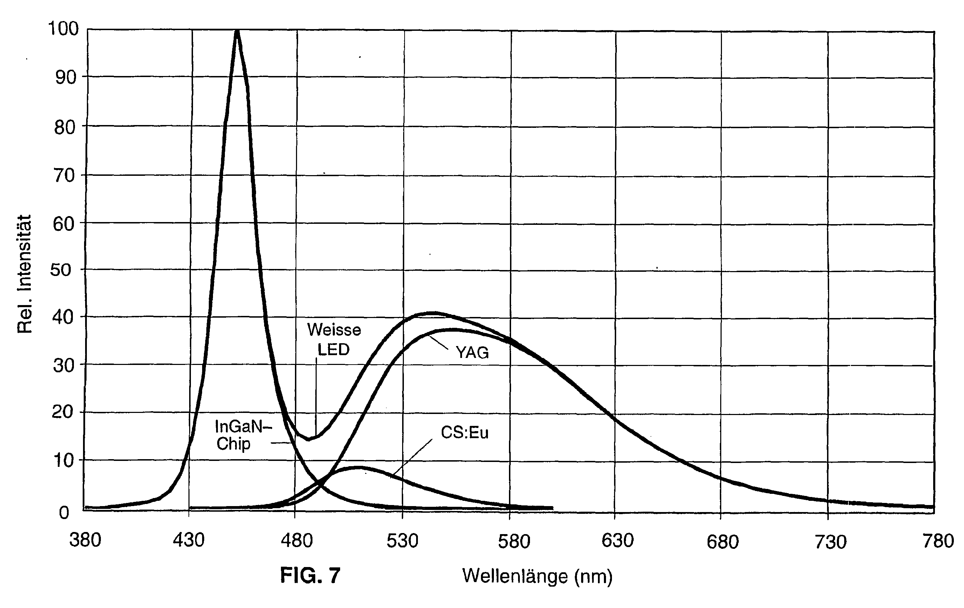

Ein weiteres bevorzugtes Ausführungsbeispiel einer weißen LED verwendet neben dem InGaN-Chip (blaue Emission bei 450 nm) die Kombination des o.e. Chlorosilikat-Leuchtstoffs (CS:Eu) mit YAG:Ce. Dieses Ausführungsbeispiel zeichnet sich durch ein extrem gleichartiges Temperaturlöschverhalten beider Leuchtstoffe aus, wie in Figur 6 deutlich wird. Das Temperaturlöschverhalten beider Leuchtstoffe ist über das zulässige Einsatzgebiet (bis etwa 100 °C) praktisch gleich und nur geringfügig von der Temperatur abhängig. Andere Granate wie beispielsweise der zu Vergleichszwecken mit untersuchte Mischgranat (Y_{0.33}Gd_{0,63}Ce_{0.04})Al₅O₁₂ zeigen eine deutlich schlechtere Temperaturkonstanz (in Figur 6 ist dieser Mischgranat als (Y,Gd)AG:Ce bezeichnet). Somit ist eine besondere Konstanz des Farborts und weiterer lichttechnischer Daten unter unterschiedlichsten Temperaturbedingungen bei diesem Ausführungsbeispiel, das in hohem Maße Y (oder auch Tb) als SE enthält (mindestens 60 mol-% des SE-Gitterplatzes) gewährleistet. Das Emissionsspektrum dieses Ausführungsbeispiels ist in Figur 7 gezeigt. Es entspricht einer Farbtemperatur von 8000 K und einem Farbort mit den Koordinaten x = 0,294 und y = 0,309. Die Farbwiedergabe ist Ra = 77. Das Mischungsverhältnis der beiden Leuchtstoffe ist 4,6:1.

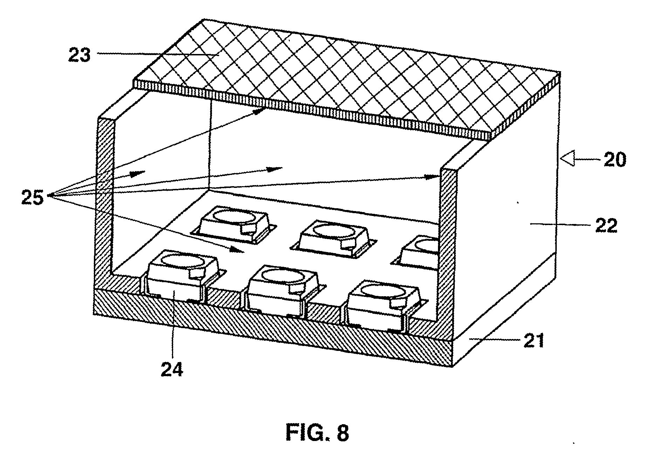

In Figur 8 ist ein Ausschnitt aus einer Flächenleuchte 20 als Beleuchtungseinheit gezeigt. Sie besteht aus einem gemeinsamen Träger 21, auf den ein quaderförmiges äußeres Gehäuse 22 aufgeklebt ist. Seine Oberseite ist mit einer gemeinsamen Abdeckung 23 versehen. Das quaderförmige Gehäuse besitzt Aussparungen, in denen einzelne Halbleiter-Bauelemente 24 untergebracht sind. Sie sind UVemittierende Leuchtdioden mit einer Peakemission von 360 nm. Die Umwandlung in weißes Licht erfolgt mittels Konversionsschichten 25, die auf allen der UV-Strahlung zugänglichen Flächen angebracht ist. Dazu zählen die innen liegenden Oberflächen der Seitenwände des Gehäuses, der Abdeckung und des Bodenteils. Die Konversionsschichten 25 bestehen aus drei Leuchtstoffen, die im gelben, grünen und blauen Spektralbereich emittieren unter Benutzung der erfindungsgemäßen Leuchtstoffe.

## Patentansprüche

1. Weiß emittierende Beleuchtungseinheit mit mindestens einer LED als Lichtquelle, wobei die LED primäre Strahlung im Bereich 300 bis 470 nm emittiert, wobei diese Strahlung teilweise oder vollständig in längerwellige Strahlung konvertiert wird durch Leuchtstoffe, die der primären Strahlung der LED ausgesetzt sind, **dadurch gekennzeichnet, dass** die Konversion zumindest unter Zuhilfenahme eines Leuchtstoffs, der grün emittiert und der aus der Klasse der Euaktivierten Calcium-Magnesium-Chlorosilikate stammt, und zumindest eines Leuchtstoffs, der gelb emittiert, und der aus der Klasse der Ce-aktivierten Seltenerd-Granate stammt, erfolgt.

2. Weiß emittierende Beleuchtungseinheit nach Anspruch 1, **dadurch gekennzeichnet, dass** der grün emittierende Leuchtstoff der Summenformel Ca_{8-x-y}EuₓMn_{y}Mg(SiO₄)₄Cl₂ mit x zwischen x = 0,005 und x = 1,6 und mit y zwischen y = 0 und y = 0,1 gehorcht, unter Einschluss der jeweiligen Eckwerte.

3. Weiß emittierende Beleuchtungseinheit nach Anspruch 1, **dadurch gekennzeichnet, dass** der gelb emittierende Leuchtstoff ein Granat der Seltenen Erden, wobei im folgenden der Begriff Seltene Erde mit SE abgekürzt ist Y, Gd, Lu, La und/oder Tb ist gemäß Formel SE₃(Al,Ga)₅O₁₂:Ce, insbesondere mit SE = Y und/oder Tb, insbesondere entsprechend der Formel YAG:Ce oder TbAG:Ce.

4. Weiß emittierende Beleuchtungseinheit nach Anspruch 1, **dadurch gekennzeichnet, dass** die primär emittierte Strahlung im Wellenlängenbereich 330 bis 370 nm liegt, wobei die primär emittierte Strahlung drei Leuchtstoffen mit Emissionsmaximum im Blauen, und zwar im Bereich 430 bis 470 nm, im Grünen, und zwar im Bereich 490 bls 525 nm, und im Gelben, und zwar im Bereich 545 bis 590 nm, ausgesetzt wird.

5. Weiß emittierende Beleuchtungseinheit nach Anspruch 1, **dadurch gekennzeichnet, dass** die primär emittierte Strahlung im blauen Wellenlängenbereich von 430 bis 470 nm liegt, wobei die primär emittierte blaue Strahlung zwei Leuchtstoffen mit Emissionsmaximum im Gelben, und zwar im Bereich 545 nm bis 590 nm, und im Grünen, und zwar im Bereich 490 bis 525 nm entsprechend einem der vorherigen Ansprüche ausgesetzt wird.

6. Weiß emittierende Lumineszenz-Konversions-LED nach Anspruch 1, **dadurch gekennzeichnet, dass** als primär Strahlungsquelle eine kurzwellig emittierende Leuchtdiode, insbesondere auf Basis von GaN oder InGaN, verwendet wird.

7. Weiß emittierende Beleuchtungseinheit nach Anspruch 1, **dadurch gekennzeichnet, dass** der Anteil des Europium zwischen x = 0,1 und x = 1,0 beträgt ohne dass zusätzlich Mn verwendet wird.

8. Weiß emittierende Beleuchtungseinheit nach Anspruch 1, **dadurch gekennzeichnet, dass** die Beleuchtungseinheit eine Lumineszenz-Konversions-LED ist, bei der die Leuchtstoffe direkt oder mittelbar in Kontakt mit dem Chip stehen.

9. Weiß emittierende Beleuchtungseinheit nach Anspruch 1, **dadurch gekennzeichnet, dass** die Beleuchtungseinheit ein Feld von LEDs ist.

10. Weiß emittierende Beleuchtungseinheit nach Anspruch 9, **dadurch gekennzeichnet, dass** zumindest einer der Leuchtstoffe auf einer vor dem LED-Feld angebrachten optischen Vorrichtung angebracht ist.

## Claims

1. White-emitting illumination unit, having at least one LED as light source, the LED emitting primary radiation in the 300 to 470 nm region, this radiation being partially or completely converted into longer-wave radiation by phosphors which are exposed to the primary radiation of the LED, **characterized in that** the conversion takes place at least with the aid of a green-emitting phosphor which originates from the class of the Eu-activated calcium magnesium chlorosilicates and of at least one yellow-emitting phosphor which originates from the class of the Ce-activated rare earth garnets.

2. White-emitting illumination unit according to Claim 1, **characterized in that** the green-emitting phosphor satisfies the empirical formula Ca_{8-x-y}EuₓMn_{y}Mg(SiO₄)₄Cl₂, where x is between x = 0.005 and x = 1.6 and y is between y = 0 and y = 0.1 (including the respective cut-off values).

3. White-emitting illumination unit according to Claim 1, **characterized in that** the yellow-emitting phosphor is a garnet of the rare earths, the term rare earths being abbreviated to RE below, Y, Gd, Lu, La and/or Tb, in accordance with the formula RE₃(Al,Ga)₅O₁₂:Ce, in particular where RE = Y and/or Tb, in particular in accordance with the formula YAG:Ce or TbAG:Ce.

4. White-emitting illumination unit according to Claim 1, **characterized in that** the primary emitted radiation lies in the 330 to 370 nm wavelength range, the primary emitted radiation being exposed to three phosphors with emission maxima in the blue region, and specifically in the 430 to 470 nm range, in the green region, and specifically in the 490 to 525 nm range, and in the yellow region, and specifically in the 545 to 590 nm range.

5. White-emitting illumination unit according to Claim 1, **characterized in that** the primary emitted radiation lies in the blue wavelength region from 430 to 470 nm, the primary emitted blue radiation being exposed to two phosphors with emission maxima in the yellow region, and specifically in the 545 nm to 590 nm range, and in the green region, and specifically in the 490 to 525 nm range as set forth in one of the preceding claims.

6. White-emitting luminescence conversion LED as according to Claim 1, **characterized in that** a short-wave light-emitting diode, in particular based on GaN or InGaN, is used as primary radiation source.

7. White-emitting illumination unit according to Claim 1, **characterized in that** the proportion of europium is between x = 0.1 and x = 1.0, without Mn additionally being used.

8. White-emitting illumination unit according to Claim 1, **characterized in that** the illumination unit is a luminescence conversion LED in which the phosphors are in direct or indirect contact with the chip.

9. White-emitting illumination unit according to Claim 1, **characterized in that** the illumination unit is an array of LEDs.

10. White-emitting illumination unit according to Claim 9, **characterized in that** at least one of the phosphors is arranged on an optical device which has been arranged in front of the LED array

## Revendications

1. Unité d'éclairage émettant de la lumière blanche et comprenant au moins une diode électroluminescente comme source de lumière, la diode électroluminescente émettant du rayonnement primaire dans le domaine allant de 300 à 470 nm, ce rayonnement étant transformé en tout ou partie en du rayonnement de plus grande longueur d'onde par des substances luminescentes qui sont exposées au rayonnement primaire de la diode électroluminescente, **caractérisée en ce que** la transformation s'effectue au moins en s'aidant d'une substance luminescente qui émet de la lumière verte et qui provient de la classe des chlorosilicates de calcium et de magnésium activés par du Eu et au moins d'une substance luminescente qui émet de la lumière jaune et qui provient de la classe des grenats de terre rare activés par du Ce.

2. Unité d'éclairage émettant de la lumière blanche suivant la revendication 1,
**caractérisée en ce que** la substance luminescente émettant de la lumière verte répond à la formule brute Ca_{8-x-y}EuₓMn_{y}Mg(SiO₄)₄Cl₂ avec x compris entre x =0,005 et x = 1,6 et avec y compris entre y = 0 et y = 0,1,
les valeurs limites respectives étant incluses.

3. Unité d'éclairage émettant de la lumière blanche suivant la revendication 1,
**caractérisée en ce que** la substance luminescente émettant de la lumière jaune est un grenat des terres rares l'expression « terre rare » étant abrégée dans ce qui suit en SE, Y, Gd, Lu La et/ou Tb suivant la formule SE₃(Al, Ga)₅O₁₂ : Ce en ayant notamment SE = Y et/ou Tb, correspondant notamment à la formule YAG :Ce et TbAG :Ce.

4. Unité d'éclairage émettant de la lumière blanche suivant la revendication 1,
**caractérisée en ce que** le rayonnement émis de façon primaire est dans le domaine des longueurs d'ondes allant de 330 à 370 nm, le rayonnement émis de façon primaire étant soumis à trois substances luminescentes ayant un maximum d'émission dans le bleu et de fait dans le domaine de 430 à 470 nm, dans le vert et de fait dans le domaine de 490 à 525 nm, et dans le jaune et de fait dans le domaine de 545 à 590 nm.

5. Unité d'éclairage émettant de la lumière blanche suivant la revendication 1,
**caractérisée en ce que** le rayonnement émis de façon primaire est dans un domaine de longueur d'onde bleu de 430 à 470 nm, le rayonnement bleu émis de façon primaire étant soumis à deux substances luminescentes ayant un maximum d'émission dans le jaune et de fait dans le domaine de 545 nm à 590 nm, et dans le vert et de fait dans le domaine de 490 à 525 nm conformément à l'une des revendications précédentes.

6. Diode électroluminescente de transformation de la luminescence émettant de la lumière blanche, **caractérisée en ce qu'**il est utilisé comme source de rayonnement primaire une diode électroluminescente émettant de courtes longueurs d'ondes, notamment à base de GAn ou de InGAn.

7. Unité d'éclairage émettant de la lumière blanche suivant la revendication 1,
**caractérisée en ce que** la proportion de l'europium est comprise entre x = 0,1 et x = 1,0, sans que du Mn supplémentaire ne soit ajouté.

8. Unité d'éclairage émettant de la lumière blanche suivant la revendication 1,
**caractérisée en ce que** l'unité d'éclairage est une diode électroluminescente de transformation de la luminescence, dans laquelle les substances luminescentes sont en contact direct ou indirect avec la puce.

9. Unité d'éclairage émettant de la lumière blanche suivant la revendication 1,
**caractérisée en ce que** l'unité d'éclairage est un champ de diodes électroluminescentes.

10. Unité d'éclairage émettant de la lumière blanche suivant la revendication 9,
**caractérisée en ce qu'**au moins l'une des substances luminescentes est mise sur un dispositif optique placé devant le champ de diodes électroluminescentes.
